# EUROPEAN PATENT APPLICATION

(11) **EP 1 972 370 A1**
(43) Date of publication of application: **24.09.2008**
(21) Application number: 06832848.3
(22) Date of filing: 17.11.2006
(51) Int. Cl.: B01D 53/68, B01D 53/70, H01L 21/3065

(54) **EMISSION GAS TREATING APPARATUS**

(30) Priority: 11.01.2006 JP 2006003554
(71) Applicant: Taiyo Nippon Sanso Corporation, Tokyo 142-8558 (JP)
(72) Inventor: SAKODA, Kaoru, Tokyo 142-8558 (JP); ISHIHARA, Yoshio, Tokyo 142-8558 (JP)
(74) Representative: Waldren, Robin Michael
(86) International application number: PCT/JP2006/322969
(87) International publication number: WO 2007/080706

(57) **Abstract**

An exhaust gas-processing apparatus of the present invention includes a gas supplier 2 which supplies a gas such as C₃F₈ to gas-using equipment 1, a detoxification device 4 which detoxifies an exhaust gas accepted from the gas-using equipment 1, a detoxifying agent-packing and -ejecting device 5, and a controller 6. The data of the types, flow rates, and supply periods of gases, which are supplied from the gas supplier 2 to the gas-using equipment 1, are sent to the controller 6. The control section 6 predicts a point in time of the break of the detoxification column 41 of the detoxification device 4 based on the data, and issues the direction of exchange so as to direct the detoxifying agent-packing and -ejecting device 5 to eject and pack detoxifying agents at a point in time of the break.

## Description

### TECHNICAL FIELD

The present invention relates to an exhaust gas-processing apparatus which removes harmful components in an exhaust gas discharged from gas-using equipment such as a dry etching device used in the production of semiconductor devices, a flat panel display, a solar cell, magnetic thin films, etc.
Priority is claimed on Japanese Patent Application No. 2006-3554, filed January 11, 2006, the content of which is incorporated herein by reference.

### BACKGROUND ART

In such an exhaust gas-processing apparatus, an exhaust gas is flowed into a detoxification column packed with detoxifying agents such as calcium oxide and calcium hydroxide so as to adsorb harmful components such as CF₄ and SiF₄ in an exhaust gas to detoxifying agents and to remove them.
Therefore, it is necessary to periodically exchange detoxifying agents in which the adsorption removal ability for harmful components is lost (hereinafter, this condition is referred to as break), and to detect a point in time at which break occurs in detoxifying agents.

Japanese Patent No. 3373763 (Patent Reference 1) discloses a method in which the discharging period at a time and the discharging flow rate are measured regarding an exhaust gas discharged from gas-using equipment, and based on the data, a point in time of break of detoxifying agents is calculated and predicted.
Also, Japanese Unexamined Patent Application, First Publication No. Hei 6-242099 (Patent Reference 2) discloses a method in which detoxifying agents having a property of discoloration due to harmful components are packed in the vicinity of the outlet of detoxification column, and the discoloration of the detoxifying agents is observed from a view port so as to detect a point in time of break.

In addition, Japanese Unexamined Patent Application, First Publication No. Hei 7-185256 (Patent Reference 3) discloses a method in which a weightmeter is placed at the bottom of a detoxification column so as to detect weight gain and the break of detoxifying agents.

However, in the method disclosed in Patent Reference 1, the concentration of harmful components in an exhaust gas is a small quantity that is lower than 1%, and the concentration may vary. Therefore, it is difficult to detect the precise point in time of break.
Also, in the method disclosed in Patent Reference 2, because the discoloration of detoxifying agents is visually confirmed, the point in time at which detoxifying agents are exchanged may be missed.
In the method disclosed in Patent Reference 3, in the case where an exhaust gas includes solid components such as SiF₄, most of the weight gain is due to these solid components, the weight gain due to the adsorption of gaseous harmful components such as CF₄ may not be able to be precisely measured.

Furthermore, in the conventional exchange of detoxifying agents that have reached break, the detoxification column is separated from an exhaust gas-processing apparatus, and then is transported to a detoxifying agent-exchanging area where the exchange is conducted. This method has a problem in that the exchange of detoxifying agents takes many steps.
[Patent Reference 1] Japanese Patent No. 3373763
[Patent Reference 2] Japanese Unexamined Patent Application, First Publication No. Hei 6-242099
[Patent Reference 3] Japanese Unexamined Patent Application, First Publication No. Hei 7-185256

### DISCLOSURE OF INVENTION

Therefore, an object of the present invention is to precisely and reliably predict a point in time of the break of detoxifying agents in an exhaust gas-processing apparatus. Also, another object of the present invention is to automatically conduct the exchange of detoxifying agents based on the predicted point in time of the break, to thereby save many steps required for the exchange.

In order to achieve the aforementioned objects, the present invention is an exhaust gas-processing apparatus which uses detoxifying agents to remove harmful components in an exhaust gas discharged from gas-using equipment, including an arithmetic processing section which determines a point in time of exchange of the detoxifying agents on the basis of a supply quantity of a gas to the gas-using equipment.

In the present invention, it is preferable to further include a detoxifying agent-packing and -ejecting section which conducts automatic exchange of the detoxifying agents in accordance with the direction from the arithmetic processing section.

According to the present invention, the harmful components and the quantities thereof in an exhaust gas from gas-using equipment are calculated on the basis of the types and the supply quantities of gases to the gas-using equipment such as C₃F₈, to thereby predict the point in time of the break of detoxifying agents. Therefore, it is possible to precisely detect the point in time of the break.
Also, by sending the data of the point in time of the break to the detoxifying agent-packing and -ejecting device, the detoxifying agents right before break occurs can be exchanged for new ones.

Accordingly, detoxifying agents can be used effectively and efficiently, and automatically exchanged at the point in time right before break. Moreover, various analyzers and detectors that are conventionally used in the break detection of detoxifying agents become unnecessary. In addition, a backup detoxification column is provided at the downstream side of a conventional exhaust gas-processing apparatus in case break occurs in a detoxification column, but this backup detoxification column becomes unnecessary.

### BRIEF DESCRIPTION OF THE DRAWINGS

FIG. 1 is a schematic diagram representing an apparatus incorporating an exhaust gas-processing apparatus of the present invention.
FIG. 2 is a schematic diagram representing an example of a control section in the present invention.

The reference numerals shown in these figures are defined as follows:
1 represents gas-using equipment; 2 represents a gas supplier; 4 represents a detoxification device; 5 represents a detoxifying agent-packing and -ejecting device; and 6 represents a control section.

### BEST MODE FOR CARRYING OUT THE INVENTION

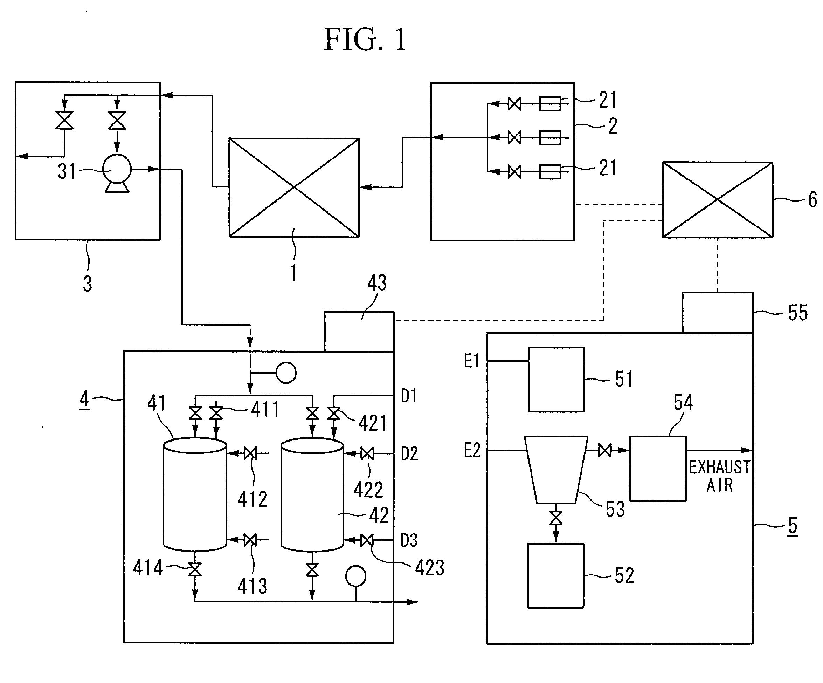

FIG. 1 represents an apparatus incorporating an exhaust gas-processing apparatus of the present invention, which includes gas-using equipment 1 such as a dry etching device, a gas supplier 2 which supplies a gas such as C₃F₈ to the gas-using equipment 1, a switching unit 3 which switches flow channels of an exhaust gas from the gas-using equipment 1, a detoxification device 4 which detoxifies an exhaust gas accepted from the gas-using equipment 1, a detoxifying agent-packing and -ejecting device 5 which ejects detoxifying agents in a detoxification column of the detoxification device 4 and packs new ones, and a controller 6 which controls these devices.
Herein an exhaust gas-processing apparatus of the present invention mainly includes the gas supplier 2, the detoxification device 4, the detoxifying agent-packing and -ejecting device 5, and the controller 6.

In the gas supplier 2, gas-supplying sources corresponding to types of gases to be supplied to the gas-using equipment 1 are provided (not shown in the figure), and for these gases, mass flow meters 21, 21... that measure the flow rates thereof are provided. Also, the flow rates and the gas supply periods for these gases are sent from these mass flow meters 21, 21 ... to the controller 6.

From the gas-using equipment 1, an exhaust gas is discharged, which includes harmful components composed of halogen-containing compounds such as SiF₄, CF₄, and C₂F₆ and purge gases such as argon, and the exhaust gas is suctioned by the pump 31 provided at the switching unit 3, and flowed into the detoxification device 4.

The detoxification device 4 includes two detoxification columns 41, 42 in which detoxifying agents such as calcium oxide and calcium hydroxide are packed, and right before break occurs in one detoxification column 41 (42), an exhaust gas is flowed into another detoxification column 42(41), to thereby enable switching operation.
Also, detoxifying agents in the detoxification column in which break occurs are automatically ejected by the detoxifying agent-packing and -ejecting device 5 described below, and then new detoxifying agents are packed in the detoxification column.
Gas discharged from the detoxification device 4, in which harmful components have been removed, is discharged outside the system.

The detoxifying agent-packing and -ejecting device 5 mainly includes a first detoxifying agent container 51 which stores new detoxifying agents, a second detoxifying agent container 52 which stores break detoxifying agents, a separator 53 which separates a mixed flow of detoxifying agents and air discharged from detoxification columns 41, 42 into detoxifying agents and air, an exhauster 54 which suctions a mixed flow of detoxifying agents and air discharged from detoxification columns 41, 42 or air of detoxification columns 41, 42, and an internal control section 55 which controls these devices.

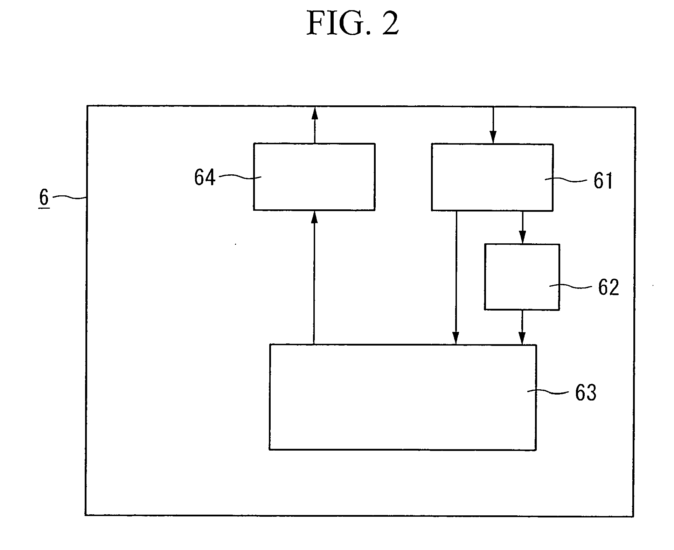

Also, the controller 6, as shown in FIG. 2, includes a signal receiver 61, a signal conversion section 62, an arithmetic processing section 63, and a signal transmitter 64.
The electrical signal regarding the flow rate and gas supply period of each type of supplied gases is input from the mass flow meters 21, 21··· into the signal receiver 61. When this electrical signal is a digital signal, it is input into the arithmetic processing section 63. Also, when the electrical signal from the mass flow meters 21, 21^{...} is an analog signal, it is once input into the signal conversion section 62, converted into a digital signal, and then input into the arithmetic processing section 63.

The arithmetic processing section 63 calculates points in time of the break of detoxifying agents in the detoxification columns 41, 42 based on the types, flow rates, and supply times of supplied gases from the mass flow meters 21, 21^{...}. More specifically, the arithmetic processing section 63 predicts the types, concentrations, and flow rates of harmful components in an exhaust gas from the gas-using equipment 1 on the basis of these data.
As for this prediction, the correlation between the types, flow rates, and supply periods of gases supplied to the gas-using equipment 1; and the types, concentrations, and discharging periods of harmful components in the exhaust gas from the gas-using equipment 1 is measured by experiment, etc. to thereby prepare the database, and this database is stored on the memory section in the arithmetic processing section 63.

When the aforementioned data are input into the arithmetic processing section 63, the calculation is performed with reference to the aforementioned database from the memory section, and the prediction is performed by obtaining the types, concentrations, and discharging periods of harmful components.
Subsequently, the obtained types, concentrations, and discharging periods of harmful components lead to the detoxifying agent quantity required for detoxification.

For example, in the case where C₃F₈ is supplied at a flow rate of 100 sccm for 10 seconds from the gas supplier 2 to the gas-using equipment 1, CF₄, C₂F₆, etc. are included in the exhaust gas from the gas-using equipment 1. The concentration of CF₄ is assumed to be 1000 ppm, and the exhaust gas thereof is assumed to be discharged for 12 seconds. However, the discharging period varies according to the length of a pipe. The concentration of C₂F₆ is assumed to be 100 ppm, and the exhaust gas thereof is assumed to be discharged for 12 seconds. On those conditions, the discharge quantities A, B, C··· of harmful components are obtained as follows.

| | | |
|---|---|---|
| CF₄ | 1000 ppm × (conversion factor) × 12 seconds | =Ag |
| C₂F₆ | 100 ppm × (conversion factor) × 12 seconds | =Bg |
| · | | =Cg |
| · | | =Dg |

When the effective processing capacity of detoxifying agents in the detoxification column is represented by Z g, a point in time at which A + B + C+ ... = Z is determined as break.

The detoxifying agent quantity required for the detoxification is compared with the detoxifying agent quantity in the detoxification columns 41, 42, which is stored on the memory section, and at a point in time at which the detoxifying agent quantity required for the detoxification corresponds to the detoxifying agent quantity in the detoxification columns 41, 42, the arithmetic processing section 63 send the detoxification column-exchanging direction signal to the signal transmitter 64. Then, this signal is sent to the internal control section 43 of the gas detoxification device 4 and the internal control section 55 of the detoxifying agent-packing and -ejecting device 5, and these internal control sections 43, 55 conduct the detoxifying agent-ejecting and -packing operation in accordance with it.

The switching operation of detoxification columns and the detoxifying agent-ejecting and -packing operation associated therewith are described hereinafter.
In the detoxification device 4, the valve 411 of the detoxification column 41 and the valve 421 of the detoxification column 42 are connected to the pipe D1, the valve 412 of the detoxification column 41 and the valve 422 of the detoxification column 42 are connected to the pipe D2, and the valve 413 of the detoxification column 41 and the valve 423 of the detoxification column 42 are connected to the pipe D3.

The exhaust gas is flowed from the switching unit 3 into the detoxification column 41, detoxified therein, and discharged through the valve 414 outside the system.
When the detoxification column-switching direction signal is sent from the signal transmitter 64 of the controller 6 to the internal control section 43 of the detoxification device 4 right before break occurs in the detoxification column 41, the valve operation is conducted, and the detoxification columns are switched, to thereby flow the exhaust gas into the detoxification column 42.
At substantially the same time, the internal control section 55 of the detoxifying agent-packing and -ejecting device 5 operates to eject the old break detoxifying agents in the detoxification column 41, followed by starting the operation to pack new detoxifying agents.

In this operation, the pipe D3 and the pipe E2 are connected firstly. Next, the valve 412 and the valve 413 are opened. The exhauster 54 is operated to suction the detoxifying agents in the detoxification column 41 accompanied with air from the valve 412 through the pipe D3, the pipe E2, and the separator 53. In the separator 53, air and the detoxifying agents are separated, and the old detoxifying agents are recovered in the second detoxifying agent container 52 which is exchanged according to need.

When all of the old detoxifying agents in the detoxification column 41 are discharged, the valve 412 and the valve 413 are closed, and the exhauster 54 is also stopped.
After the detoxifying agents in the detoxification column 41 are ejected, the detoxifying agent-packing operation-starting signal is sent from the signal transmitter 65 of the controller 6 to the internal control section 55 of the detoxifying agent-packing and -ejecting device 5 and the internal control section 43 of the gas detoxification device 4, followed by starting the packing operation.

Firstly, the pipe D1 and the pipe E 1 are connected, and the pipe D2 and the pipe E2 are connected. Next, the exhauster 54 is operated, the valve 412 is opened, and the pressure inside the detoxification column 41 is reduced to be negative. Subsequently, the valve 411 is opened, and new detoxifying agents stored in the first detoxifying agent container are flowed into the detoxification column 51, and packed. The quantity of the packed detoxifying agents is evaluated by the weight change of the first detoxifying agent container 51.
After the end of the packing, the valve 411 is closed, and the exhauster 54 is stopped.

In the case where the detoxification of harmful components in the detoxification column 42 proceeds and the break of detoxifying agents therein approaches, the same operation is conducted for the detoxification column 42, too. By repeating this operation, the detoxification of harmful components in the exhaust gas continuously proceeds.

In the aforementioned exhaust gas-processing apparatus, the data of the types, flow rates, and supply periods of gases such as C₃F₈, which are supplied from the gas supplier 2 to the gas-using equipment 1, are sent to the arithmetic processing section 63 in which the calculation is performed based on the data, to thereby predict the types, concentrations, and discharging periods of harmful components such as CF₄ in the exhaust gas. Accordingly, the detoxifying agent quantity required for detoxification can be predicted, and the break of detoxifying agents can be preliminarily detected with precision. Therefore, the point in time of switching the detoxification columns 41, 42 is not missed.

Also, the present invention includes the detoxifying agent-packing and -ejecting device 5, and in accordance with the direction from the controller 6, old detoxifying agents can be automatically ejected from the detoxification column 41(42), followed by packing new detoxifying agents. Accordingly, the switching operation of the detoxification column 41(42) and the exchanging operation of detoxifying agents can be automatically conducted without manpower.

In addition, various analyzers and detectors that are conventionally used in the detection of break of detoxifying agents become unnecessary. In addition, a backup detoxification column is provided at the downstream side of a conventional exhaust gas-processing apparatus in case where break occurs in a detoxification column, but it is possible to obtain the advantageous effect that the backup detoxification column becomes unnecessary.

### INDUSTRIAL APPLICABILITY

According to the present invention, various analyzers and detectors that are conventionally used in the break detection of detoxifying agents, and a backup detoxification column provided in case where break occurs in a detoxification column become unnecessary. Therefore, the present invention is industrially useful.

## Claims

1. An exhaust gas-processing apparatus which uses detoxifying agents to remove harmful components in an exhaust gas discharged from gas-using equipment, comprising an arithmetic processing section which determines a point in time of exchange of the detoxifying agents based on a supply quantity of a gas to the gas-using equipment.

2. An exhaust gas-processing apparatus according to claim 1, further comprising a detoxifying agent-packing and -ejecting section which conducts automatic exchange of the detoxifying agents in accordance with the direction from the arithmetic processing section.
